# EUROPÄISCHE PATENTANMELDUNG

(11) **EP 1 975 993 A1**
(43) Veröffentlichungstag der Anmeldung: **01.10.2008**
(21) Anmeldenummer: 07105236.9
(22) Anmeldetag: 29.03.2007
(51) Int. Cl.: H01L 21/58, H01L 21/60, H05K 3/34

(54) **Lötstoppmittel**

(71) Anmelder: ABB Technology AG, 8050 Zurich (CH)
(72) Erfinder: Trüssel, Dominik, CH-5620 Bremgarten (CH); Chen, Makan, CH-5102 Rupperswil (CH); Schneider, Daniel, CH-8112 Otelfingen (CH); Schlapbach, Ulrich, CH-3097 Liebefeld (CH)
(74) Vertreter: ABB Patent Attorneys

(57) **Zusammenfassung**

Ein Lötstoppmittel umfasst einen ersten Draht (2), welcher auf der Oberfläche eines Trägers (1) gebondet ist. Der erste Draht (2), welcher wenigstens abschnittsweise um eine Lötfläche (3) herum angeordnet ist, ist an mindestens zwei Bondstellen (7) gebondet, wobei jeweils zwei Bondstellen (7) um einen Bondabstand (6) voneinander beabstandet sind.

## Beschreibung

### Technisches Gebiet

Die Erfindung bezieht sich auf Lötstoppmittel gemäss Oberbegriff des Patentanspruches 1.

### Stand der Technik

Lötstoppmittel werden bei der Herstellung von elektronischen Komponenten, insbesondere Halbleitermodulen, verwendet, um ein ungewünschtes Ausbreiten eines Lotes zu verhindern. Auf einem elektrisch isolierenden Substrat, welches typischerweise selektiv metallisch beschichtet ist, werden elektrisch leitende Elemente wie beispielsweise ein Halbleiterchip fest gelötet. Dies geschieht mit einem Hochtemperaturlot, z.B. einer Bleilegierung mit geringen Anteilen (<10%) von Zinn und Silber, wobei das Löten abhängig vom verwendeten Lot bei einer Temperatur von typischerweise über 300 °C, meist bei 330 bis 370 °C durchgeführt wird. Beim Löten muss darauf geachtet werden, dass das Lot sich nicht zu weit auf dem Substrat ausbreitet, insbesondere, dass das Lot nicht bis zu einem Bereich der Metallisierung ausbreitet, welcher nicht mit dem Lot elektrisch leitend verbunden werden soll. Das Problem wird verstärkt, wenn nach dem ersten Lötprozess ein weiterer Lötprozess durchgeführt wird, um weitere Element auf dem Substrat anzulöten, z.B. externe Terminals zur elektrischen Kontaktierung der Chips, oder um das Substrat auf eine Basisplatte zu löten. Damit sich bei diesem zweiten Lötschritt das erste Lot nicht wieder verflüssigt, wird ein anderes Lot verwendet, z.B. eutektische Blei-Zinnlote mit oder ohne geringen Anteilen von Silber oder bleifreie Zinnlote mit geringen Anteilen von Silber, Kupfer, Antimon oder Bismut, welche sich bereits bei niedrigeren Temperaturen von etwa 170 bis 240 °C verflüssigen. Es werden auch Lötplättchen eingesetzt, welche nur lokal erhitzt werden.

Weitverbreitet ist auch die Verwendung einer elektrisch isolierenden Paste, ein sogenannter Lötstopplack, welcher zwischen den beiden Lötstellen auf das Substrat in einem Siebdruckverfahren aufgebracht wird, um eine unerwünschte Ausbreitung des Lotes und eine Vermischung der zwei unterschiedlichen Lote zu verhindern. Der Lötstopplack kann ein durch Licht aushärtbares Polymer sein, welcher inorganisches Füllmaterial enthalten kann, z.B. SiO₂, und welcher typischerweise nur bis etwa 250 °C stabil ist. Bei höheren Temperaturen kann es zu einer Ablösung oder Beschädigung der Lackschicht kommen, so dass die Lackschicht dann nicht mehr zuverlässig eine Ausbreitung des Lotes verhindern kann. Durch das Ablösen können ausserdem Lufteinschlüsse entstehen, welche vor allem beim Anlegen höherer Spannungen zu Teilentladungen führen können. Des weiteren kann der Lötstoplack von Lösungsmitteln angegriffen werden, die in nachfolgenden Prozessschritten verwendet werden, z.B. für das Aufbringen einer Polyimidschicht. Dies kann zu Blasenbildung im Lötstoplack führen und damit die Isolationsfähigkeit des Substrates reduzieren.

Ein anderes Mittel zur Verhinderung des Ausbreitens von Lot ist das Ätzen einer Struktur auf der Oberfläche eines Substrats, welches ein mechanisches Hindernis für das Lot darstellt.

In DE 103 51 120 wird ein Verfahren vorgestellt, bei welchem mit einem Laser Gräben in dem Substrat geschaffen werden, so dass das Lot mittels eines Lasers geschaffenen Grabens gestoppt wird. Durch die Einwirkung des Laserstrahls kann eine Oxidation des Trägermaterials unter dem Laser auftreten, durch welche Lot diesen Bereich schlechter benetzen kann und somit die Ausbreitung von Lot begrenzt wird. Der Graben kann weiterhin einen Wall aufweisen, welcher während der Herstellung des Grabens durch Abfliessen des durch den Laser verflüssigten Materials zu einer Seite des Grabens hin erzeugt wird. Das in DE 103 51 120 beschriebene Lötstoppmittel kann jedoch nur eingesetzt werden auf hinreichend dicken Substraten, welche zudem durch Laser verflüssigbar sein müssen. Die beim Erzeugen des Grabens mit dem Laser entstehenden Temperaturen sind sehr hoch, so dass auch Elemente auf dem Substrat unerwünscht verflüssigt, angelöst oder beschädigt werden können, beispielsweise die Metallisierungen auf dem Substrat. Ausserdem ist eine hohe Kontrolle der Lasertechnik (beispielsweise Laserleistung, Einfallswinkel des Laserstrahls, Fortschrittsgeschwindigkeit auf der Oberfläche, Intensitätsverteilung über den Strahlquerschnitt und das Querschnittsprofil selbst) notwendig, um einen gleichmässigen Graben zu schaffen, wobei auch das Material des Trägers, beziehungsweise eine Variation der Materialzusammensetzung oder selektive Beschichtungen auf dem Träger sowie eine Variation der Dicke des Trägers das Ergebnis des Lasern beeinflusst.

### Darstellung der Erfindung

Aufgabe der Erfindung ist, ein einfaches Lötstoppmittel anzugeben, durch welches ein zuverlässiges Stoppen eines Lotes ermöglicht wird und welches leicht herzustellen ist.

Diese Aufgabe wird erfindungsgemäss durch ein Lötstoppmittel mit den Merkmalen des Anspruchs 1 gelöst. Das erfindungsgemässe Lötstoppmittel umfasst einen ersten Draht, welcher auf der Oberfläche eines Trägers gebondet ist. Der erste Draht ist wenigstens abschnittsweise um eine vorgesehene Lötfläche auf dem Träger herum angeordnet. Der erste Draht ist an mindestens zwei Bondstellen gebondet, wobei jeweils zwei Bondstellen zueinander um einen Bondabstand beabstandet sind.

Die Lösung hat den Vorteil, dass das Lötstoppmittel einfach herzustellen ist. Da beim Bondverfahren zum Herstellen des Lötstoppmittels keine hohen Temperaturen notwendig sind, wird der Träger zudem nicht übermässig thermisch belastet. Das Bonden ist ein gängiges Verfahren, welches beispielsweise bei elektronischen Komponenten eingesetzt wird, um elektrische Drahtverbindungen zu schaffen. Die Technologie ist einfach zu handhaben, ohne dass temperaturempfindliche Prozesse während der Herstellung notwendig sind oder temperaturempfindliche Lötstoppmittel, welche bei Betrieb unzuverlässig werden könnten, z.B. durch Ablösen, erforderlich sind. Die Dicke des Trägers, auf der das Lötstoppmittel geschaffen wird, bleibt vollständig erhalten, so dass keine mechanische Schwächung des Trägers an der Stelle des Lötstoppmittels entsteht. Das erfindungsgemässe Lötstoppmittel kann weiterhin als Positionierungshilfe verwendet werden, um ein fest zu lötendes Element und das Lot selber in der gewünschten Position für den Lötprozess zu fixieren und somit ein Verschieben des zu lötenden Elements oder des Lotplättchens zu verhindern, was während der Verflüssigung des Lotes schnell passieren kann.

Der Draht kann direkt zwischen den Bondstellen auf der Oberfläche des Trägers aufliegen, so dass kein Lot zwischen Draht und Träger bei einem späteren Lötprozess hindurch fliessen kann. Das erfinderische Lötstoppmittel bezieht sich aber auch auf Drähte, durch welche zwischen zwei Bondstellen eine Öffnung zwischen Draht und Träger ausgebildet ist. Eine solche Öffnung kann beispielsweise durch das Herstellverfahren bedingt sein. Durch die Biegungen des Drahtes, welche die Öffnungen formen, können unterschiedliche Ausdehnungen der Materialien bei erhöhten Temperaturen während der Herstellung oder während des Betriebs ausgeglichen werden, so dass mechanischer Stress reduziert wird.

Weitere vorteilhafte Ausgestaltungen der Erfindung sind in den Unteransprüchen angegeben.

### Kurze Beschreibung der Zeichnungen

Im folgenden wird das erfindungsgemässe Verfahren und der Erfindungsgegenstand anhand eines bevorzugten Ausführungsbeispiels, welches in den beiliegenden Zeichnungen dargestellt ist, näher erläutert. Es zeigt:
- Figur 1: einen Schnitt durch eine erste Ausführungsform eines erfindungsgemässen Lötstoppmittels;
- Figur 2: eine Aufsicht auf eine weitere Ausführungsform eines erfindungsgemässen Lötstoppmittels;
- Figur 3: einen Schnitt durch eine weitere Ausführungsform eines erfindungsgemässen Lötstoppmittels gemäss der Linie A -A in Fig. 2; und
- Figur 4: einen Schnitt durch eine weitere Ausführungsform eines erfindungsgemässen Lötstoppmittels gemäss der Linie A -A in Fig. 2.

### Wege zur Ausführung der Erfindung

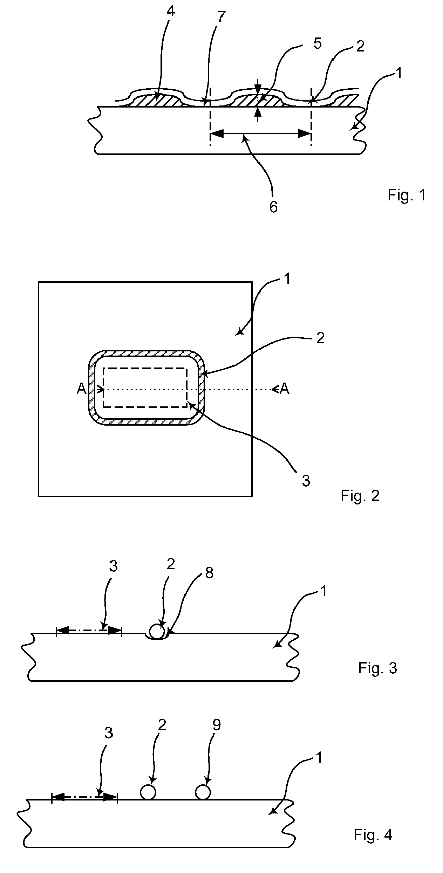

Fig. 1 zeigt ein erfindungsgemässes Lötstoppmittel mit einem Träger 1 in Form einer Schicht, typischerweise ein Substrat aus elektrisch isolierendem Material, welches selektive metallische Beschichtungen aufweist. Das Lötstoppmittel umfasst einen ersten Draht 2, welcher wenigstens abschnittsweise um eine Lötfläche 3 herum angeordnet ist und an mindestens zwei Bondstellen 7 auf der Schicht 1 gebondet ist, wobei jeweils zwischen zwei Bondstellen 7 um einen Bondabstand 6 voneinander beabstandet sind. Der Draht 2 wird typischerweise aus Aluminium oder einer Aluminium-Legierung gefertigt. Es sind aber auch andere Metalle oder Metalllegierungen denkbar, welche in Zusammenwirken mit dem Trägermaterial für ein Bondverfahren geeignet sind, beispielsweise Gold, Silber oder Kupfer. Der erste Draht 2 kann direkt auf der Schicht angeordnet sein, das heisst, der Draht 2 ist vollständig entlang seiner Längsachse mit der Schicht 1 in Kontakt.

Alternativ ist es aber auch denkbar, dass jeweils zwischen zwei Bondstellen 7 eine Öffnung 4 ausgebildet ist, welche eine Höhe 5 zwischen dem Draht 2 und der Schicht 1 aufweist. Die Öffnungen 4 sind in Fig. 1 als schraffierte Fläche zwischen zwei Bondstellen 7 dargestellt. Die Öffnung 4 weist jeweils eine derart kleine Grösse auf, dass kein Lot einer auf der Schicht 1 durchgeführten Lötung durch die Öffnung 4 fliessen kann. Die Höhe der Öffnung 5 beträgt gemäss einer bevorzugten Ausführungsform maximal 200 µm, vorzugsweise 50 µm und gemäss einer weiteren bevorzugten Ausführungsform 30 µm. Der Bondabstand 6 zwischen zwei Bondstellen 7 beträgt jeweils maximal 1 mm und vorzugsweise maximal 0.8 mm. Die maximale Grösse der Öffnung 4 hängt dabei von bekannten Eigenschaften des Lotes wie der Art des Lotes, der Menge des verwendeten Lotes, der Benetzungseigenschaften des Lotes auf Schicht 1 und von den für die Lötung erforderlichen Verfahrensbedingungen wie der Temperatur während des Lötens und beispielsweise des Druckes während des Lötens und somit von der Viskosität des Lotes während des Erhitzens ab. Die Bondstellen 7 können in regelmässigem Bondabstand zueinander angeordnet sein.

In Fig. 2 ist eine Aufsicht auf eine weitere erfindungsgemässe Ausführungsform gezeigt. Der erste Draht 2 (als schraffierter Bereich dargestellt) umschliesst die gestrichelt eingezeichnete Lötfläche 3 vollständig, d.h. der Draht 2 bildet eine geschlossene Kurve um die Fläche 3, auf der eine Lötung vorgenommen werden soll, so dass zu keiner Seite der Lötfläche 3 Lot austreten kann. Der Draht 2 kann natürlich auch so angeordnet sein, dass er ein Austreten des Lotes nur abschnittsweise, beispielsweise zu einer Seite verhindert. Dies kann vorteilhaft sein, wenn das Austreten des Lotes nur abschnittsweise kritisch ist oder wenn es aufgrund der geometrischen Gegebenheiten (Platzverhältnisse) vorteilhaft ist, den Draht 2 nur stellenweise anzuordnen.

Fig. 3 zeigt einen Schnitt durch eine weitere Ausführungsform des erfindungsgemässes Lötstoppmittel entlang der gepunktet gezeichneten Linie A - A aus Fig. 2. Der erste Draht 2 ist dabei in einer Vertiefung 8 in der Oberfläche des Trägers 1 angeordnet. Dabei kann die Vertiefung 8 entweder so gestaltet sein, dass die Form der Vertiefung 8 der Form des ersten Drahtes 2, welcher in der Vertiefung zu liegen kommt, entspricht, das heisst, dass der erste Draht 2 bündig in der Vertiefung 8 liegt, so dass der Draht 2 durch die Vertiefung 8 geführt und somit in seiner Position gehalten wird.

Alternativ ist es aber auch denkbar, dass zwischen der Vertiefung 8 und dem Draht 2 ein Zwischenraum ausgebildet ist, so dass Lot, sobald es während des Lötens zum Lötstoppmittel fliesst, zuerst in die Vertiefung 8 fliesst und dann als weiteres mechanisches Hindernis auf den ersten Draht 2 trifft. Natürlich kann das erfindungsgemässe Lötstoppmittel auch einen ersten Draht 2 und eine Vertiefung 8 aufweisen, welche in unterschiedlichem Abstand von der Lötfläche 3 angeordnet sind, d.h. dass der Draht nicht in der Vertiefung 8 angeordnet ist, so dass das Lot nacheinander auf den ersten Draht 2 und dann auf die Vertiefung 8 trifft oder umgekehrt.

Fig. 4 zeigt ebenfalls einen Schnitt durch eine weitere Ausführungsform des erfindungsgemässes Lötstoppmittel entlang der gepunktet gezeichneten Linie A - A aus Fig. 2. Auf dem Träger 1 ist ein zweiter Draht 9 angeordnet, welcher als zusätzliche Barriere für ein flüssiges Lot dient. Dieser zweite Draht 9 wird wenigstens abschnittsweise in einem anderen Abstand von der Lötfläche 3 als der erste Draht 2 angeordnet, so dass das Lot nacheinander von der Lötfläche 3 in Richtung zum ersten Draht 2 und zweiten Draht 9 fliesst und wenigstens von einem der Drähte als Lötstoppmittel vom Ausbreiten gehindert wird. Ein solches doppeltes Lötstoppmittel kann auch dazu verwendet werden, um sicherzustellen, dass zwei Lötstellen elektrisch voneinander getrennt sind.

Für die Herstellung eines Lötstoppmittels auf einem Träger 1 wird ein erster Draht 2 wenigstens abschnittsweise um eine Lötfläche 3 herum an mindestens zwei Bondstellen 7 auf der Oberfläche des Trägers 1 gebondet. Jeweils zwei Bondstellen 7 sind um einen Bondabstand 6 voneinander beabstandet. Als Bondverfahren kann jedes für den Bonddraht geeignete Bondverfahren verwendet werden. Gebräuchliche Bondverfahren sind dafür Thermokompressionsbonden, Thermosonic-Ball-Wedge Bonden und Ultraschall-Wedge-Wedge Bonden. Das Ultraschall-Bonden wird oftmals bei Aluminiumdraht eingesetzt. Der Draht wird für das Bonden durch eine Bonddrahtführung geleitet und unter Druck und Ultraschall mit der Oberfläche des Trägers verschweisst. Das Verfahren eignet sich besonders für die Herstellung von Lötstoppmitteln, weil für das Verfahren keine Wärme zugeführt werden muss. Das Bonden des ersten Drahtes 2 wird typischerweise nach einem ersten Löten mit einem ersten Lot bei einer ersten Temperatur durchgeführt, welche typischerweise über 300 °C, oft bei 330 bis 370 °C liegt. Das Bonden des ersten Drahtes 2 erfolgt konsequenterweise vor dem zweiten Löten, bei dem er als Lotstoppmittel dient. Dieses zweite Löten erfolgt typischerweise zwischen 200 und 280°C.

Es ist auch möglich, das erste Löten als Niedertemperatur-Löten unter gegenüber dem Normaldruck erhöhtem Druck bei einer gegenüber einem normalen Löten, das heisst gegenüber einem Löten bei Normaldruck verringerter Temperatur durchzuführen. Dazu werden Schichten aus Metall oder einer Metalllegierung als Lot, beispielsweise Silber und Indium Schichten zwischen die zu lötenden Elemente angeordnet. Temperaturen von 160 bis 400 °C und ein Druck von 0 N/mm² bis 1.5 N/mm² wirkt für kurze Zeit, zwischen 10 s und 10 min, auf die zu verbindenden Elemente ein, was zur Verlötung der Elemente miteinander führt. Ein solches Verfahren ist beispielsweise aus der Patentschrift US 6,334,567 bekannt.

## Patentansprüche

1. Lötstoppmittel, **dadurch gekennzeichnet, dass** das Lötstoppmittel einen ersten Draht (2) umfasst, welcher auf der Oberfläche eines Trägers (1) gebondet ist, dass der erste Draht (2) wenigstens abschnittsweise um eine Lötfläche (3) herum angeordnet ist, dass der erste Draht (2) an mindestens zwei Bondstellen (7) gebondet ist und dass jeweils zwei Bondstellen (7) um einen Bondabstand (6) voneinander beabstandet sind.

2. Lötstoppmittel nach Anspruch 1, **dadurch gekennzeichnet, dass** jeweils zwischen zwei Bondstellen (7) eine Öffnung (4) ausgebildet ist, welche eine Höhe (5) zwischen dem ersten Draht (2) und dem Träger (1) von maximal 200 µm aufweist.

3. Lötstoppmittel nach Anspruch 2, **dadurch gekennzeichnet, dass** die Höhe (5) der Öffnung jeweils maximal 50 µm beträgt.

4. Lötstoppmittel nach Anspruch 2, **dadurch gekennzeichnet, dass** die Höhe (5) der Öffnung jeweils maximal 30 µm beträgt.

5. Lötstoppmittel nach einem der vorangegangenen Ansprüche, **dadurch gekennzeichnet, dass** der Bondabstand (6) jeweils maximal 1 mm und vorzugsweise 0.8 mm beträgt.

6. Lötstoppmittel nach einem der Ansprüche 2 bis 4, **dadurch gekennzeichnet, dass** die Bondstellen (7) in regelmässigem Bondabstand (6) zueinander angeordnet sind.

7. Lötstoppmittel nach einem der vorangegangenen Ansprüche, **dadurch gekennzeichnet, dass** der erste Draht (2) aus Aluminium oder einer Aluminium-Legierung gefertigt ist.

8. Lötstoppmittel nach einem der vorangegangenen Ansprüche, **dadurch gekennzeichnet, dass** der erste Draht (2) in einer Vertiefung (8) in der Oberfläche des Trägers (1) angeordnet ist oder eine Vertiefung (8) in der Oberfläche des Trägers (1) wenigstens abschnittsweise in einem anderen Abstand von der Lötfläche (3) als der erste Draht (2) angeordnet ist.

9. Lötstoppmittel nach einem der vorangegangenen Ansprüche, **dadurch gekennzeichnet, dass** der erste Draht (2) die Lötfläche (3) vollständig umschliesst.

10. Lötstoppmittel nach einem der vorangegangenen Ansprüche, **dadurch gekennzeichnet, dass** ein zweiter Draht (9) auf der Oberfläche eines Trägers (1) gebondet ist, dass der zweite Draht (9) an mindestens zwei Bondstellen (7) gebondet ist und dass jeweils zwei Bondstellen (7) um einen Bondabstand (6) voneinander beabstandet sind, wobei der zweite Draht (9) wenigstens abschnittsweise in einem anderen Abstand von der Lötfläche (3) als der erste Draht (2) angeordnet ist.
